# EUROPEAN PATENT SPECIFICATION

(11) **EP 2 948 271 B1**
(45) Date of publication and mention of the grant of the patent: **08.05.2019**
(21) Application number: 14702711.4
(22) Date of filing: 16.01.2014
(51) Int. Cl.: B24B 37/26, B24B 37/20, B24B 37/22

(54) **POLISHING PAD HAVING POLISHING SURFACE WITH CONTINUOUS PROTRUSIONS**
POLIERKISSEN MIT POLIEROBERFLÄCHE MIT KONTINUIERLICHEN VORSPRÜNGEN
TAMPON DE POLISSAGE POURVU D'UNE SURFACE DE POLISSAGE PRÉSENTANT DES PROTUBÉRANCES CONTINUES

(30) Priority: 22.01.2013 US 201313747139
(43) Date of publication of application: 02.12.2015
(73) Proprietor: CABOT MICROELECTRONICS CORPORATION, Aurora, IL 60504 (US)
(72) Inventor: LEFEVRE, Paul Andre, Portland, Oregon 97229 (US); ALLISON, William C., Beaverton, Oregon 97006 (US); SIMPSON, Alexander William, Hillsboro, Oregon 97124 (US); SCOTT, Diane, Portland, Oregon 97212 (US); HUANG, Ping, Beaverton, Oregon 97006 (US); CHARNS, Leslie M., Portland, Oregon 97225 (US); RINEHART, James Richard, Portland, Oregon 97219 (US); KERPRICH, Robert, Portland, Oregon 97229 (US)
(74) Representative: J A Kemp
(86) International application number: PCT/US2014/011792
(87) International publication number: WO 2014/116491

(56) References cited:
- EP-A1- 1 447 841
- WO-A1-2009/025748
- JP-A- 2000 246 629
- JP-A- 2005 183 707
- JP-A- 2005 183 712
- US-A- 6 093 651
- US-A1- 2008 160 890
- US-A1- 2012 094 586
- US-A1- 2013 017 764
- US-B1- 6 332 832
- US-B1- 6 495 464
- US-B1- 6 500 054
- US-B1- 7 238 093

## Description

### TECHNICAL FIELD

Embodiments of the present invention are in the field of chemical mechanical polishing (CMP) and, in particular, polishing pads having a polishing surface with cylindrical protrusions continuous with the polishing body.

### BACKGROUND

Chemical-mechanical planarization or chemical-mechanical polishing, commonly abbreviated CMP, is a technique used in semiconductor fabrication for planarizing a semiconductor wafer or other substrate.

The process uses an abrasive and corrosive chemical slurry (commonly a colloid) in conjunction with a polishing pad and retaining ring, typically of a greater diameter than the wafer. The polishing pad and wafer are pressed together by a dynamic polishing head and held in place by a plastic retaining ring. The dynamic polishing head is rotated during polishing. This approach aids in removal of material and tends to even out any irregular topography, making the wafer flat or planar. This may be necessary in order to set up the wafer for the formation of additional circuit elements. For example, this might be necessary in order to bring the entire surface within the depth of field of a photolithography system, or to selectively remove material based on its position. Typical depth-of-field requirements are down to Angstrom levels for the latest sub-50 nanometer technology nodes.

The process of material removal is not simply that of abrasive scraping, like sandpaper on wood. The chemicals in the slurry also react with and/or weaken the material to be removed. The abrasive accelerates this weakening process and the polishing pad helps to wipe the reacted materials from the surface. In addition to advances in slurry technology, the polishing pad plays a significant role in increasingly complex CMP operations.

However, additional improvements are needed in the evolution of CMP pad technology.

US 7 238 093 B1 discloses a CMP cloth in accordance with the pre-characterizing section of claim 1.

### SUMMARY

According to an aspect of the present invention there is provided the polishing pad of claim 1.

Additional aspects of the invention are set out in the dependent claims.

### BRIEF DESCRIPTION OF THE DRAWINGS

Figure 1 illustrates a top-down plan view of a concentric circular groove pattern disposed in the polishing surface of a conventional polishing pad.
Figure 2A illustrates a top-down plan view of a cylindrical protrusion pattern disposed in the polishing surface of a polishing pad, not in accordance with the present invention.
Figure 2B is an enlarged view of the protrusion pattern of a portion of Figure 2A.
Figure 2C is a cross-sectional view taken along the a-a' axis of Figure 2B.
Figure 3A illustrates an exemplary center field for the polishing pad of Figures 2A-2C where the polishing surface includes a button region having a triangular clocking mark on one side of the hexagonal shape of the button.
Figure 3B illustrates an exemplary outer field for the polishing pad of Figures 2A-2C where the polishing surface includes a solid ring encompassing the plurality of cylindrical protrusions at an outer most edge of the polishing side of the polishing body.
Figure 4 illustrates options for the polishing surface shape of a cylindrical protrusion such as a circle ("A"), an oval ("B"), a triangle ("C"), a pentagon ("D") and a hexagon ("E"), in accordance with an embodiment of the present invention.
Figure 5A illustrates a pattern of cylindrical protrusions in a hexagonal packed arrangement, not in accordance with the present invention.
Figure 5B illustrates a pattern of cylindrical protrusions in a square packed arrangement, not in accordance with the present invention.
Figure 5C illustrates a pattern of cylindrical protrusions in a generally square packed arrangement, with larger spacing between groupings of protrusions, not in accordance with the present invention.
Figure 6A illustrates a pattern of cylindrical protrusions in a generally hexagonal packed arrangement, with larger spacing between substantially square or rectangular shaped groupings of protrusions, not in accordance with the present invention.
Figure 6B illustrates a pattern of cylindrical protrusions in a generally hexagonal packed arrangement, with larger spacing between rhombic shaped groupings of protrusions, in accordance with an embodiment of the present invention.
Figure 6C illustrates a pattern of cylindrical protrusions in a generally hexagonal packed arrangement, with larger spacing between triangular shaped groupings of protrusions, not in accordance with the present invention.
Figure 6D illustrates a pattern of cylindrical protrusions in a generally hexagonal packed arrangement, with larger spacing between strip-based shaped groupings of protrusions, not in accordance with the present invention.
Figure 7 illustrates a pattern of cylindrical protrusions in a generally hexagonal packed arrangement, with larger spacing between rhombic shaped groupings of protrusions, the rhombic shaped groupings arranged in sub-patterns, in accordance with an embodiment of the present invention.
Figure 8A illustrates an angled plan view of a modified quadrilateral protrusion pattern disposed in the polishing surface of a polishing pad, not in accordance with the present invention.
Figure 8B illustrates an exemplary center field for the polishing pad of Figure 8A where the polishing surface includes a button region having a modified square shape.
Figure 8C illustrates an exemplary outer field for the polishing pad of Figure 8A where the polishing surface includes a solid ring encompassing the plurality of modified quadrilateral protrusions at an outer most edge of the polishing side of the polishing body.
Figure 9A illustrates options for the polishing surface shape of a modified quadrilateral polishing protrusion, such as a square with four rounded corners, a square with four notched corners, and a square with four arced sides, not in accordance with the present invention.
Figure 9B illustrates options for the quadrilateral shape used as a foundation for a modified quadrilateral polishing protrusion, such as a modified-square shape, a modified-rectangular shape, a modified-rhombus shape, and a modified-trapezoidal shape, not in accordance with the present invention.
Figure 10 illustrates a top-down plan view of a protrusion pattern, the pattern interrupted by a local area transparency (LAT) region and/or an indication region, disposed in the polishing surface of a polishing pad, not in accordance with the present invention.
Figures 11A-11F illustrate cross-sectional views of operations used in the fabrication of a polishing pad, not in accordance with the present invention.
Figure 12 illustrates an isometric side-on view of a polishing apparatus compatible with a polishing pad having a polishing surface with continuous protrusions, not in accordance with the present invention.

### DETAILED DESCRIPTION

Polishing pads having a polishing surface with continuous protrusions are described herein. In the following description, numerous specific details are set forth, such as specific polishing pad designs and compositions, in order to provide a thorough understanding of embodiments of the present invention. In other instances, well-known processing techniques, such as details concerning the combination of a slurry with a polishing pad to perform chemical mechanical planarization (CMP) of a semiconductor substrate, are not described in detail in order to not unnecessarily obscure embodiments of the present invention. Furthermore, it is to be understood that the various embodiments shown in the figures are illustrative representations and are not necessarily drawn to scale.

Polishing pads for polishing substrates in CMP operations typically include at least one surface with physical grooves or protrusions formed therein. The grooves or protrusions may be arranged to balance an appropriate amount of surface area for polishing the substrate while providing a reservoir for slurry used in the CMP operation. In accordance with embodiment of the present invention, protrusion patterns are described for polishing surfaces of polishing pads.

Protrusion patterns described herein may provide benefits for, or may be advantageous over prior art polishing pads for, polishing substrates in a CMP operation using slurry. For example, advantages of protrusion patterns described herein may include (a) improved averaging of a slurry-based polish process across a polished substrate as the polishing pad is rotated relative to a polished substrate, and (b) improved slurry retention on the polishing pad relative to pads with conventional groove or protrusion patterns.

Basic embodiments of the present invention include the use of protrusion features having relatively similar values for all dimensions within a polishing plane of the polishing surface. Embodiments of the invention include the use of cylindrical protrusions. The protrusions may be formed by a molding process, as such protrusion shapes would typically otherwise be impractical to form by cutting a pattern into a polishing surface.

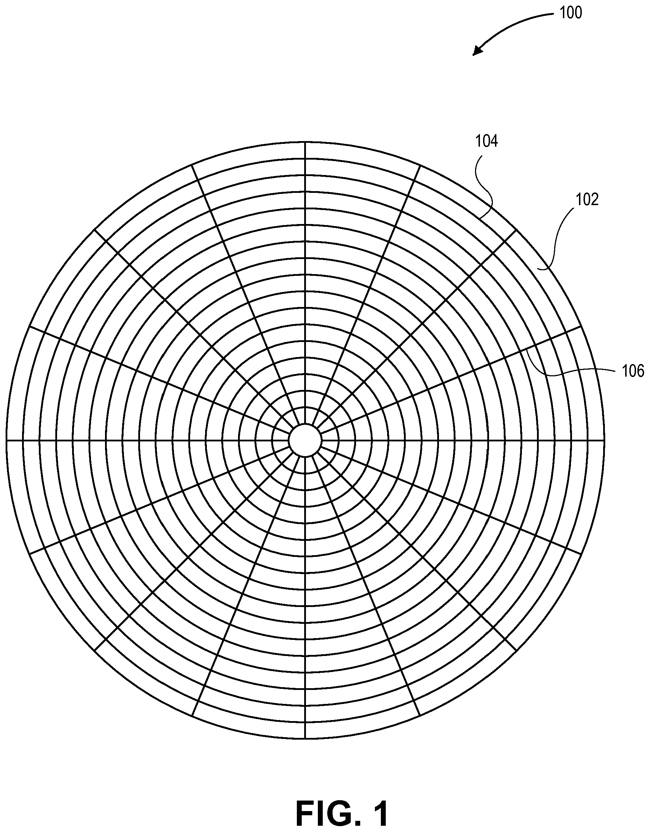

Conventional polishing pads typically have concentric circular groove patterns with radial grooves there through. For example, Figure 1 illustrates a top-down plan view of a concentric circular groove pattern disposed in the polishing surface of a conventional polishing pad.

Referring to Figure 1, a polishing pad 100 includes a polishing body having a polishing surface 102 and a back surface (not shown). The polishing surface 102 has a pattern of grooves of concentric circles 104. The pattern of grooves also includes a plurality of radial grooves 106 continuous from the inner most circle to the outer most circle, as depicted in Figure 1. The potential drawbacks of such a groove pattern can include poor averaging of slurry distribution across large concentric grooves and/or slurry loss by drainage along radial grooves.

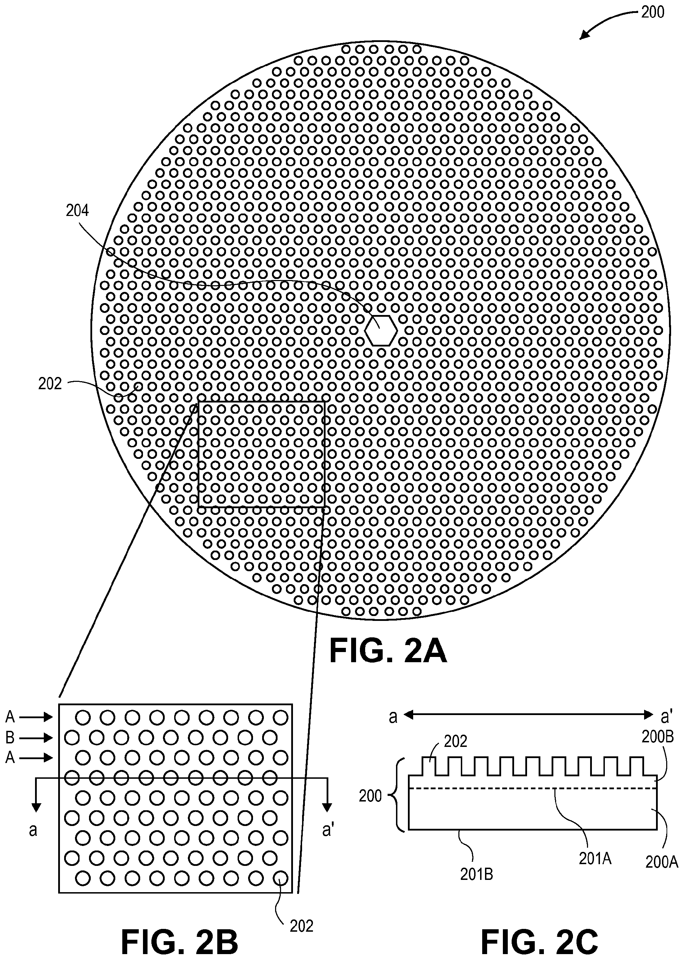

In contrast to Figure 1, and as exemplified in Figure 2A below, show patterns of protrusions which are spaced narrowly relative to conventional groove spacing. Furthermore, all dimensions of the protrusions in a plane of the polishing surface are relatively similar and, hence, each protrusion can be effective for providing consistent localized polishing characteristics. By avoiding conventional grooving, slurry retention on the polishing pad may be improved by the use of such protrusions.

According to the present invention, a polishing pad is fabricated with a polishing surface having a pattern of continuous cylindrical protrusions thereon. As an example, Figure 2A illustrates a top-down plan view of a cylindrical protrusion pattern disposed in the polishing surface of a polishing pad, not in accordance with the present invention. Figure 2B is an enlarged view of the protrusion pattern of a portion of Figure 2A, while Figure 2C is a cross-sectional view taken along the a-a' axis of Figure 2B.

Referring to Figures 2A and 2C, a polishing pad 200 includes a polishing body (shown as 200A in Figure 2C). The polishing body has a polishing side 201A opposite a back surface 201B. The polishing pad 200 also includes a polishing surface, as seen in the top-down view of Figure 2A and referred as 200B of Figure 2C. The polishing surface has a plurality of cylindrical protrusions 202 continuous with the polishing side 201A of the polishing body 200A. Referring to Figure 2B, an enlarged view of field detail of exemplary protrusions 202 is provided. The portion of the pad 200 shown in Figure 2C is a cross-sectional view of the portion enlarged in Figure 2B.

Referring again to Figure 2C, the cylindrical protrusions 202 are continuous in the sense that they form a common unified polishing surface layer, best seen as a unified region 200B. The continuous nature of the cylindrical protrusions is in contrast to discrete protrusions, such as affixed tiles, that are in no way connected to one another on a surface to which they are affixed. Furthermore the polishing surface 200B and the polishing body are unified. In that case, the dotted line showing separation between regions 200A and 200B is provided merely as a visual aid for conceptualizing the difference between the polishing body and polishing surface regions of a polishing pad. Furthermore the polishing body 200A and polishing surface 200B are together both homogeneous and unitary. The polishing body 200A and polishing surface 200B are composed of a same molded polyurethane material, exemplary details of which are provided below.

Referring again to Figure 2B, the plurality of cylindrical protrusions 202 may be arranged in a global pattern with at least some level of repetition. For example, in one embodiment as illustrated in Figure 2B, the plurality of protrusions 202 is arranged in a hexagonal packed patterned in that rows of the cylindrical protrusions are staggered in an ABA arrangement. Other exemplary arrangements are described in greater detail below.

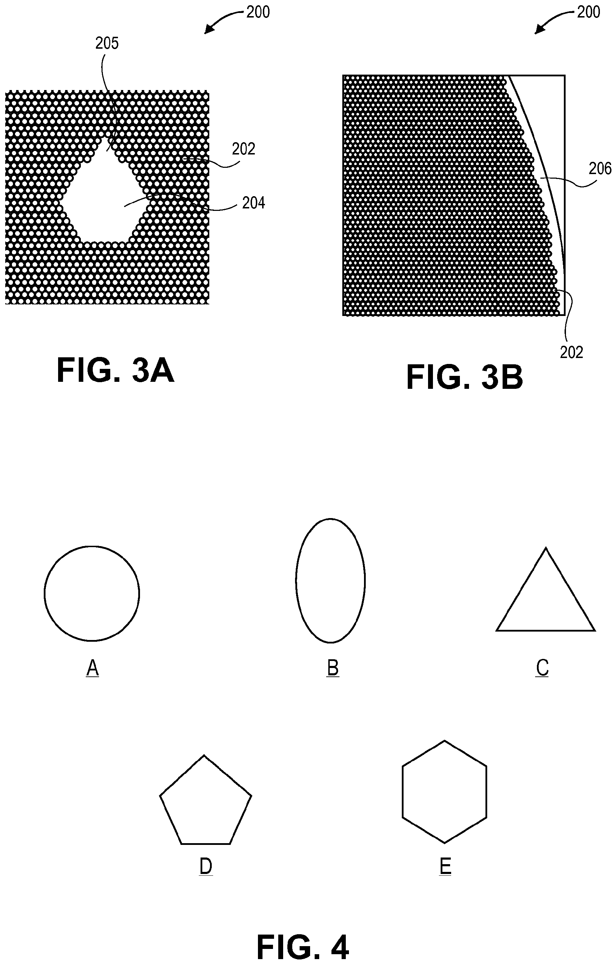

Referring again to Figure 2A, the polishing pad 200 may include a central button 204. The button 204 can be a raised portion of pad material (e.g., co-planar and continuous with the cylindrical protrusions 202) that provides a region for pad property testing. Polishing is not performed in the region of button 204. The button 204 may a shape compatible with the overall pattern of cylindrical protrusions 202. In an exemplary embodiment, referring to Figures 2A and 3A (the latter illustrating a center field portion of pad 200), the plurality of protrusions 202 has a global hexagonal packed arrangement, and button 204 has a hexagonal shape. Furthermore, the button 204 may include a clocking feature which provides pad fabrication information and/or alignment information for polishing or for adhering a pad to a platen. Referring to Figure 3A, the button region 204 further includes a triangular clocking mark on one side of the hexagonal shape. The hexagonal center button 204 is approximately 25,4 mm (1 inch) across, and the clocking mark 205 is triangular on one face of the hexagon.

The outer portion of polishing pad 200 may be tailored for specific polishing purposes. For example, Figure 3B illustrates an exemplary outer field for the polishing pad of Figures 2A-2C where the polishing surface includes a solid ring 206 encompassing the plurality of cylindrical protrusions 202 at an outer most edge of the polishing side of the polishing body. As depicted in Figure 3B, a hexagonal-packed pattern of cylindrical protrusions 202 terminates proximate to the ring 206 in a staggered arrangement. The solid outer ring 206 has an average width of approximately 3,175 mm (125 mils). The inner edge of the solid outer ring 206 is shaped to avoid large down space, while providing an edge of the pad 200 that is continuous and has a dam effect on slurry. Overall, however, the solid ring may have an irregular shape that follows the contour of the pattern of cylindrical protrusions, as is depicted in figure 3B.

Referring again to Figures 2A, 2B, 3A and 3B, each of the cylindrical protrusions 202 are depicted to have a circular shape in a plane of the polishing surface of the polishing pad 200. However, other cylindrical shapes may also be suitable for providing an effective polishing surface. Thus, the term "cylindrical" is not limited to protrusions have a top-down circular profile. Rather, as used in embodiments herein, a cylindrical protrusion is one that maintains a same shape in a vertical direction (e.g., has essentially or precisely vertical sidewalls) throughout the protrusions. The cylindrical profile describes the nature of the protrusions having approximately the same dimension in all 360 degrees of the protrusion shape. This is, the cylindrical protrusions 202 are distinguished from a large arcing grove type polishing feature. In one embodiment, the cylindrical protrusion shape is one that would otherwise be impractical to achieve by merely cutting a pattern into a polishing surface, e.g., in some form of an XY grid cutting approach (such as cylinders having basic square or basic rectangular geometries as viewed from the top-down of the cylindrical protrusion). For example, Referring to Figure 4, each of the plurality of cylindrical protrusions 202 of polishing pad 200 has a shape in a plane of the polishing surface such as, but not limited to, a circle ("A" from Figure 4; also used as exemplary cylindrical protrusion in Figures 2A, 2B), an oval ("B" from Figure 4), a triangle ("C" from Figure 4), or a polygon having five or more sides (e.g., the pentagon "D" from Figure 4, or the hexagon "E" from Figure 4). The cylindrical protrusions 202 are formed by a molding process, as described in greater detail below. It is noted that all of these options for the cylindrical protrusions 202 all have the same cross-sectional shape as viewed in Figure 2C.

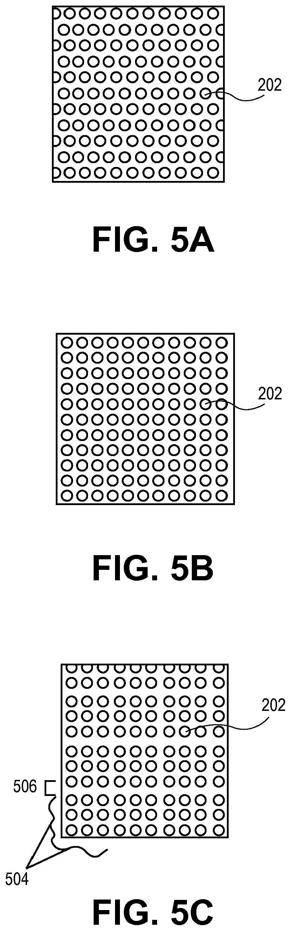

Referring again to Figures 2A, 2B, 3A and 3B showing pads not according to the invention, the pattern of the plurality of protrusions 202 is not limited to a hexagonal packed arrangement. Other arrangements may also provide a packing of cylindrical protrusions suitable for polishing a substrate or wafer. Referring to Figure 5B, a plurality of cylindrical protrusions 202 is arranged in a square-packed pattern, in that all successive rows of protrusions are aligned with one another. This is in contrast to the staggered arrangement resulting from hexagonal packing, illustrated again in Figure 5A for comparison. The cylindrical protrusions 202 are arranged in a randomized pattern, with effectively no long range pattern repetition.

Additionally, the spacing between protrusions need not always be the same. For example, groupings of tighter spaced protrusions may be arranged with larger spacings between groupings in order to provide channels between the grouping. That is, a pattern of cylindrical protrusions is arranged to have a plurality of high density regions having less spacing between adjacent protrusions within a high density region as compared to spacing between adjacent protrusions of adjacent high density regions. Figure 5C illustrates a pattern of cylindrical protrusions 202 in a generally square packed arrangement, with larger spacing between groupings of protrusions. Referring to Figure 5C, a grouping 504 has less spacing between protrusions 202 within grouping 504 than the spacing 506 between adjacent groupings. In the specific example, of Figure 5C, an XY channel arrangement results between groupings. The inclusion of such channels may be used for slurry transport or for modifying other polishing characteristics of a polishing pad. Furthermore, since the protrusions are molded and not cut, the spacing between grouping can be varied beyond simple removal of one row or column of protrusions between grouping, as would other wise be required for cutting of a pattern.

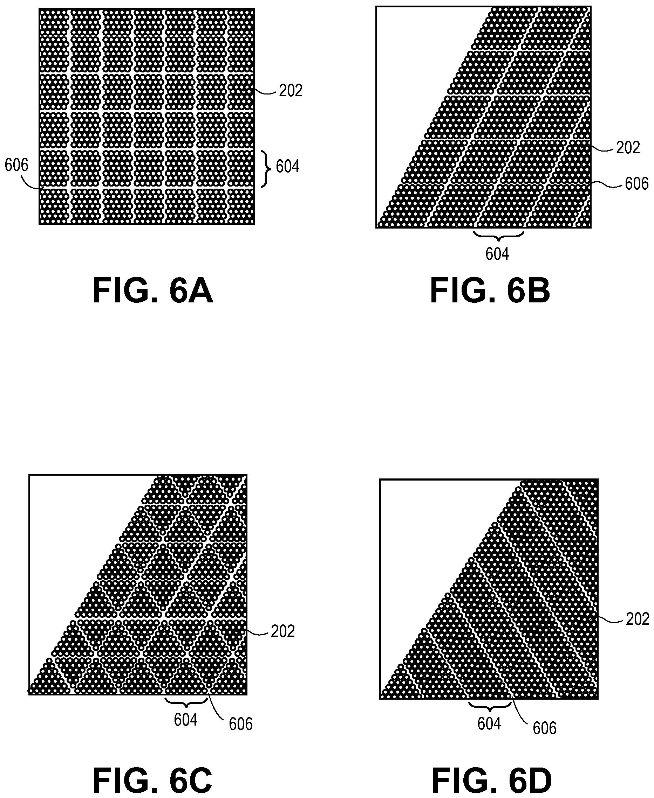

With reference to the description of Figure 5C, groupings of protrusions 202, with larger spacing between such groupings, may also be based on a generally hexagonal packed arrangement of protrusions. For example, in an embodiment, a pattern of cylindrical protrusions 202 includes high density regions 604 are arranged in a hexagonal-packed pattern with larger spacings 606 between such high density groupings (e.g., ultimately forming channels). The high density regions can, have a general shape such as, but not limited to, a substantially square or rectangular shape with spacing between each of the high density regions based on an X-Y grid pattern (Figure 6A), a rhombic shape (Figure 6B), a triangular shape (Figure 6C), or a strip-based shape (Figure 6D).

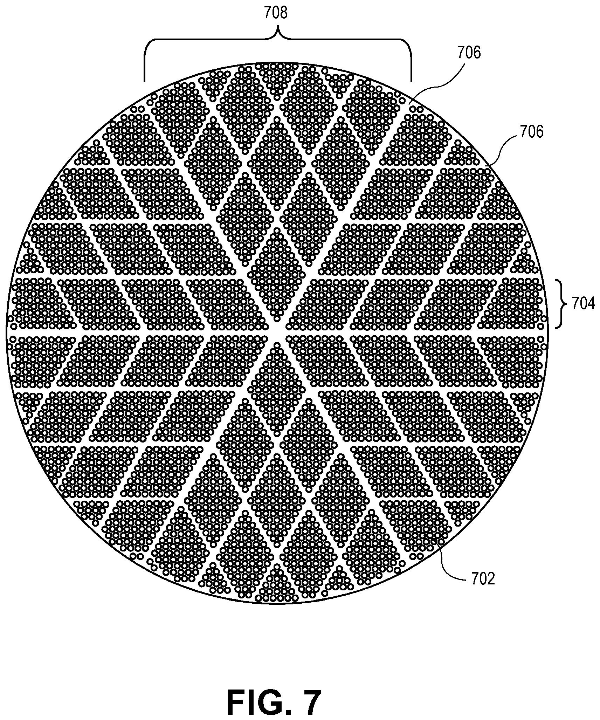

The above described high density regions can have sub-patterns that combine to form one larger pattern based on pad orientation. In an embodiment of the invention, Figure 7 illustrates a pattern of cylindrical protrusions 702 in a generally hexagonal packed arrangement, with larger spacing 706 between rhombic shaped groupings 704 of protrusions, the rhombic shaped groupings arranged in sub-patterns 708, in accordance with an embodiment of the present invention. Effectively, a sub-pattern 708 of the high density regions 704 is repeated every 60 degree rotation of the polishing pad. The result is a pattern that originates from a central point 710, as depicted in Figure 7.

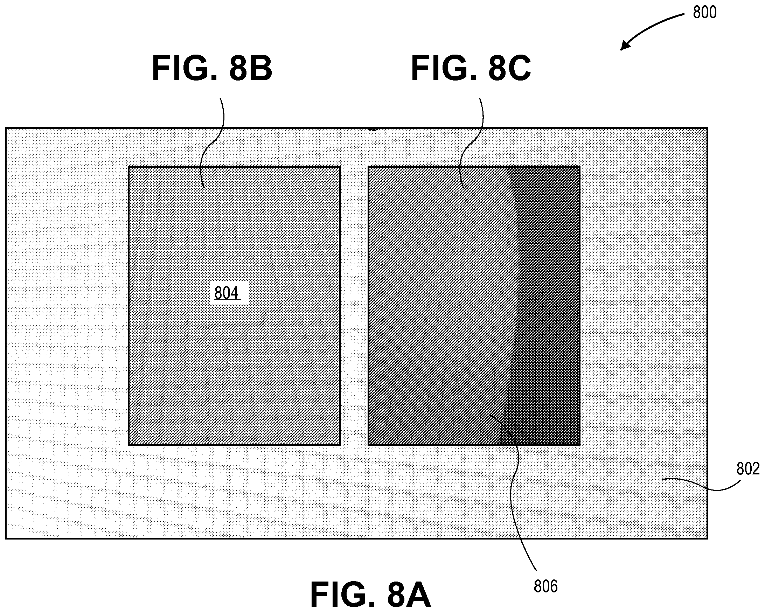

A polishing pad not according to the invention may be fabricated with a polishing surface having a pattern of continuous protrusions based on a modified quadrilateral shape thereon. As an example, Figure 8A illustrates an angled plan view of a modified quadrilateral protrusion pattern disposed in the polishing surface of a polishing pad. Referring to Figure 8A, a polishing pad 800 includes a polishing body and a polishing surface having a plurality of protrusions 802 continuous with the polishing side of the polishing body. Each protrusion 802 has a modified-quadrilateral polygon shape in a plane of the polishing surface.

Similar to the protrusions 202 of pad 200, e.g., as described in association with Figure 2C, the protrusions 802 of polishing pad 800 are continuous in the sense that they form a common unified polishing surface layer. The continuous nature of the protrusions 802 is in contrast to discrete protrusions, such as affixed tiles, that are in no way connected to one another on a surface to which they are affixed. Furthermore, the polishing surface and the polishing body of polishing pad 800 are unified. Furthermore, the polishing body and polishing surface of polishing pad 800 are together both homogeneous and unitary, exemplary details of materials for which are provided below.

Referring again to Figure 8A, the plurality of cylindrical protrusions 802 may be arranged in a global pattern with at least some level of repetition. For example, as illustrated in Figure 8A, the plurality of protrusions 802 is arranged in a square packed patterned in that rows of the protrusions 802 form an XY grid arrangement. Other arrangements may be similar to those described above in association with polishing pad 200. For example, similar to Figures 5C, 6A-6D and 7, the plurality of protrusions 802 is arranged in a plurality of high density regions having less spacing between adjacent protrusions within a high density region than between adjacent protrusions of adjacent high density regions. Each of the high density regions is substantially square or rectangular, and spacing or channels between each of the high density regions of the plurality of high density regions forms an X-Y grid pattern. The plurality of protrusions 802 has a hexagonal packed or a randomized pattern.

Referring now to inset Figure 8B, the polishing pad 800 may include a central button 804. The button 804 can be a raised portion of pad material (e.g., co-planar and continuous with the protrusions 802) that provides a region for pad property testing. Polishing is not performed in the region of button 804. The button 804 may a shape compatible with the overall pattern of protrusions 802. Referring to Figure 8B, the plurality of protrusions 802 has a global square packed (or XY grid) arrangement, and button 804 has a modified square shape (in this case, a square having four notched corners). Furthermore, although not depicted the button 204 may include a clocking feature which provides pad fabrication information and/or alignment information for polishing or for adhering a pad to a platen. In one such embodiment, the button region 804 further includes a clocking mark on one side of the modified square shape.

Referring now to inset Figure 8C, the outer portion of polishing pad 800 may be tailored for specific polishing purposes. For example, 8C provides an exemplary outer field for the polishing pad 800 where the polishing surface includes a solid ring 806 encompassing the plurality of cylindrical protrusions 802 at an outer most edge of the polishing side of the polishing body. The solid ring 806 is continuous with the polishing side of the polishing body, and a continuous groove is disposed between the solid ring and the plurality of protrusions 802. The continuous edge of the ring 806 can provide a good location for sealing for backside pad cutting and/or providing an edge of the pad 800 that is continuous and has a dam effect on slurry.

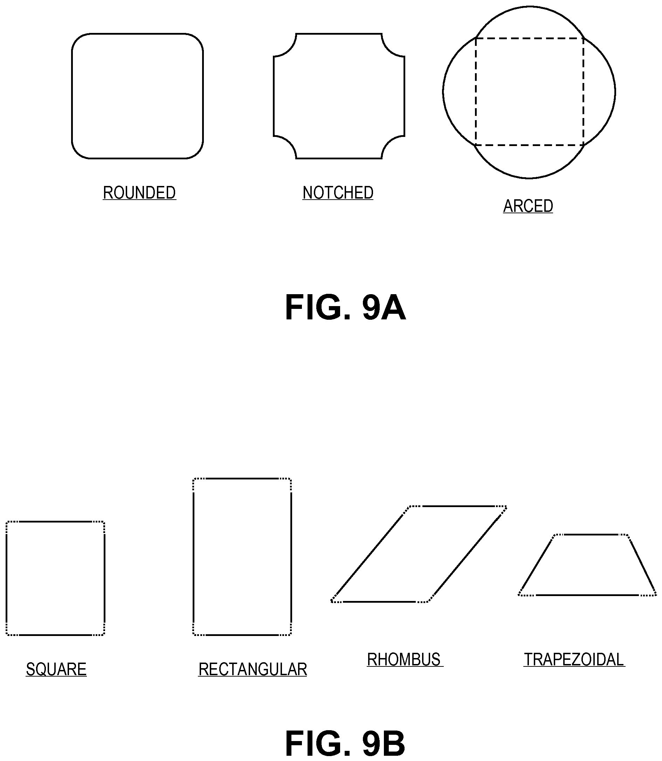

Referring again to Figures 8A-8C, each of the protrusions 802 are depicted to have a square shape will all four corners rounded shape in a plane of the polishing surface of the polishing pad 800. However, other modified quadrilateral shapes may also be suitable for providing an effective polishing surface. The modified quadrilateral shape describes the nature of the protrusions having approximately the same dimension in all 360 degrees of the protrusion shape. This is, the protrusions 802 are distinguished from a large arcing grove type polishing feature. The modified quadrilateral protrusion shape is one that would otherwise be impractical to achieve by merely cutting a pattern into a polishing surface, e.g., in some form of an XY grid cutting approach (such as tiles or protrusions having basic square or basic rectangular geometries as viewed from the top-down of the protrusion). For example, Referring to Figure 9A, each of the plurality of modified quadrilateral protrusions 802 of polishing pad 800 has a modification in a plane of the polishing surface such as, but not limited to, one or more rounded corners (a square with four rounded corners is shown in Figure 9A), a one or more notched corners (a square with four notched corners is shown in Figure 9A), or one or more arced sides (a square with four arced sides is shown in Figure 9A). In one such embodiment, the modified quadrilateral protrusions 802 are formed by a molding process, as described in greater detail below.

As mentioned briefly above, the modified quadrilateral shape of protrusions 802 can be one which has one or more corners modified. Referring to Figure 9B, quadrilateral shapes used as a foundation may include, but are not limited to, a modified-square shape, a modified-rectangular shape, a modified-rhombus shape, or a modified-trapezoidal shape. It is noted that the corners of the quadrilateral shapes of Figures 9B are depicted with dotted lines, indication that shape modification (such as rounding or notching) may be situated at one or more of these locations. Other options include arcing one or more of the sides of the shapes, as described in association with Figure 9A. Furthermore, in one embodiment, the modified quadrilateral protrusions are cylindrical in that each protrusion maintains a same shape in a vertical direction (e.g., has essentially or precisely vertical sidewalls) throughout the protrusion. It is noted that all such options for the cylindrical protrusions have the same cross-sectional shape similar to the shape depicted in Figure 2C.

Polishing pads described herein, such as polishing pad 200 or 800, or the above described variations thereof, each of the polishing protrusions (e.g., the polishing protrusions described in association with Figures 2A-2C, 3A, 3B, 4, 5A-5C, 6A-6D, 7, 8A-8C, 9A and 9B) has a maximum lateral dimension approximately in the range of 1 - 30 millimeters. For example, in the case of a circular shaped cylindrical protrusion, the maximum lateral dimension is the diameter of the circle. In the case of a modified square shape, the maximum lateral dimension is the dimension spanning the modified square shape in the plane of the polishing surface. A spacing between protrusions is approximately in the range of 0.1 - 3 millimeters, and can be the same across the pad (e.g., as described in association with Figure 5B) or can vary across the pad (e.g., as described in association with Figure 5C). The number of protrusions on a polishing surface can vary by application and/or pad size. In an exemplary embodiment, a polishing pad having a diameter approximately in the range of 736,6 - 812,8 mm (29-32 inches) includes approximately between 50,000 and 200,000 protrusions. In an embodiment, the height of each protrusion on a polishing pad is approximately in the range of 0.5 - 1 millimeter.

Within a same polishing surface of a polishing pad, in an embodiment, the above described protrusions need not all be same size. For example, in one embodiment, in a same polishing surface, a first of protrusions has a first maximum lateral dimension, while each protrusion of a second portion of protrusions has a second, different, maximum lateral dimension. In a specific and exemplary such embodiment, a pattern of a plurality of protrusions includes a protrusion having a maximum lateral dimension of approximately 10 millimeters surrounded by a plurality of protrusions each having a maximum lateral dimension of approximately 1 millimeter.

Additionally or alternatively, within a same polishing surface of a polishing pad, in an embodiment, the above described protrusions need not all have a same shape. For example, in one embodiment, each protrusion of a first portion of protrusions on the polishing surface has a first shape in a plane of the polishing surface, while each protrusion of a second portion of protrusions has a second, different, shape in the plane of the polishing surface. Furthermore or alternatively, within a same polishing surface of a polishing pad, in an embodiment, the above described protrusions need not all have a same height. However, the highest point of all protrusions may be co-planar (e.g., the portions of each of the protrusions that is in contact with a wafer or substrate during polishing forms a substantially planar surface). For example in one embodiment, each protrusion of a first portion of protrusions has a first height from the polishing body, while each protrusion of a second portion of protrusions has a second, different, height from the polishing body. Nonetheless, all of the protrusions from the first and second portions are substantially co-planar distal from the polishing body. Such an arrangement may enable formation of reservoirs or other slurry handling features within the polishing pad while maintaining a planar polishing surface.

Polishing pads described herein, such as polishing pad 200 or 800, or the above described variations thereof, the total surface area of the plurality of protrusions is a portion approximately in the range of 40 - 80 % of the total surface area of the polishing side of the polishing body. Protrusions that are hexagonal packed circular cylinders (e.g., as described in association with Figures 2B and 5A) having a diameter of approximately 2.032 mm (80 mils) and a spacing of approximately 0,508 mm (20 mils) provide a contact area of protrusion surface of approximately 58%. Protrusions that are square packed circular cylinders (e.g., as described in association with Figure 5B) having a diameter of approximately 2,032 mm (80 mils) and a spacing of approximately 0,406 mm (16 mils) provide a contact area of protrusion surface of approximately 54.5%. Protrusions that are square packed circular cylinders and having XY channels between regions of protrusions (e.g., as described in association with Figure 5C) having a diameter of approximately 2,032 mm (80 mils) and a spacing of approximately 0,406 (16 mils) or approximately 0,889 mm (35 mils) between regions at the XY channels, provides contact area of protrusion surface of approximately 48%. Protrusions that are molded squares with rounded corners packed in an XY grid (e.g., as described in association with Figure 8A) having a maximum lateral dimension of approximately 3,048 mm (120 mils) and a spacing of approximately 1,016 mm (40 mils) provides a contact area of protrusion surface of approximately 54.3%.

Polishing pads described herein, such as polishing pad 200 or 800, or the above described variations thereof, are suitable for polishing substrates. The substrate may be one used in the semiconductor manufacturing industry, such as a silicon substrate having device or other layers disposed thereon. However, the substrate may be one such as, but not limited to, a substrates for MEMS devices, reticles, or solar modules. Thus, reference to "a polishing pad for polishing a substrate," as used herein, is intended to encompass these and related possibilities.

Polishing pads described herein, such as polishing pad 200 or 800, or the above described variations thereof, may be composed of a homogeneous polishing body of a thermoset polyurethane material. In an embodiment, the homogeneous polishing body is composed of a thermoset, closed cell polyurethane material. In an embodiment, the term "homogeneous" is used to indicate that the composition of a thermoset, closed cell polyurethane material is consistent throughout the entire composition of the polishing body. For example, in an embodiment, the term "homogeneous" excludes polishing pads composed of, e.g., impregnated felt or a composition (composite) of multiple layers of differing material. In an embodiment, the term "thermoset" is used to indicate a polymer material that irreversibly cures, e.g., the precursor to the material changes irreversibly into an infusible, insoluble polymer network by curing. For example, in an embodiment, the term "thermoset" excludes polishing pads composed of, e.g., "thermoplast" materials or "thermoplastics" - those materials composed of a polymer that turns to a liquid when heated and returns to a very glassy state when cooled sufficiently. It is noted that polishing pads made from thermoset materials are typically fabricated from lower molecular weight precursors reacting to form a polymer in a chemical reaction, while pads made from thermoplastic materials are typically fabricated by heating a pre-existing polymer to cause a phase change so that a polishing pad is formed in a physical process. Polyurethane thermoset polymers may be selected for fabricating polishing pads described herein based on their stable thermal and mechanical properties, resistance to the chemical environment, and tendency for wear resistance.

In an embodiment, the homogeneous polishing body, upon conditioning and/or polishing, has a polishing surface roughness approximately in the range of 1 - 5 microns root mean square. In one embodiment, the homogeneous polishing body, upon conditioning and/or polishing, has a polishing surface roughness of approximately 2.35 microns root mean square. In an embodiment, the homogeneous polishing body has a storage modulus at 25 degrees Celsius
in the range of 30 - 120 megaPascals (MPa). In another embodiment, the homogeneous polishing body has a storage modulus at 25 degrees Celsius approximately less than 30 megaPascals (MPa). In one embodiment, the homogeneous polishing body has a compressibility of approximately 2.5%. In one embodiment, the homogeneous polishing body has a density in the range of 0.70 - 1.05 grams per cubic centimeter.

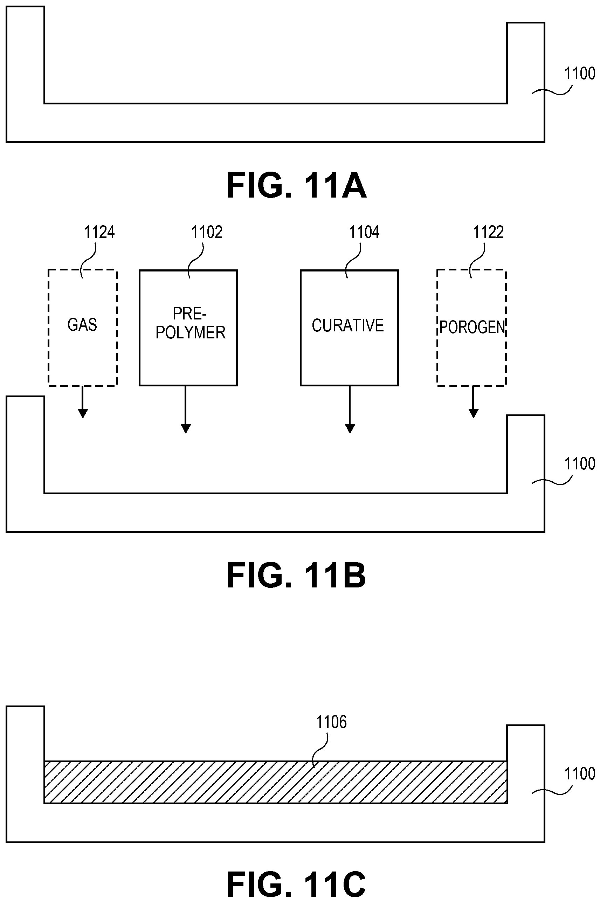

Polishing pads described herein, such as polishing pad 200 or 800, or the above described variations thereof, include a molded homogeneous polishing body. The term "molded" is used to indicate that a homogeneous polishing body is formed in a formation mold, as described in more detail below in association with Figures 11A-11F.

Polishing pads described herein, such as polishing pad 200 or 800, or the above described variations thereof, include a polishing body having a plurality of closed cell pores therein. In one embodiment, the plurality of closed cell pores is a plurality of porogens. For example, the term "porogen" may be used to indicate micro- or nano-scale spherical or somewhat spherical particles with "hollow" centers. The hollow centers are not filled with solid material, but may rather include a gaseous or liquid core. In one embodiment, the plurality of closed cell pores is composed of pre-expanded and gas-filled EXPANCEL™ distributed throughout (e.g., as an additional component in) a homogeneous polishing body of the polishing pad. In a specific embodiment, the EXPANCEL™ is filled with pentane. In an embodiment, each of the plurality of closed cell pores has a diameter in the range of 10 - 100 microns. In an embodiment, the plurality of closed cell pores includes pores that are discrete from one another. This is in contrast to open cell pores which may be connected to one another through tunnels, such as the case for the pores in a common sponge. In one embodiment, each of the closed cell pores includes a physical shell, such as a shell of a porogen, as described above. In another embodiment, however, each of the closed cell pores does not include a physical shell. In an embodiment, the plurality of closed cell pores is distributed essentially evenly throughout a thermoset polyurethane material of a homogeneous polishing body. In one embodiment, the homogeneous polishing body has a pore density in the range of 6% - 50% total void volume, and possibly in the range of 15% - 35% total void volume. In one embodiment, the homogeneous polishing has a porosity of the closed cell type, as described above, due to inclusion of a plurality of porogens.

In an embodiment, the homogeneous polishing body is opaque. In one embodiment, the term "opaque" is used to indicate a material that allows approximately 10% or less visible light to pass. In one embodiment, the homogeneous polishing body is opaque in most part, or due entirely to, the inclusion of an opacifying lubricant throughout (e.g., as an additional component in) the homogeneous thermoset, closed cell polyurethane material of the homogeneous polishing body. In a specific embodiment, the opacifying lubricant is a material such as, but not limited to: boron nitride, cerium fluoride, graphite, graphite fluoride, molybdenum sulfide, niobium sulfide, talc, tantalum sulfide, tungsten disulfide, or Teflon.

The sizing of the homogeneous polishing body may be varied according to application. Nonetheless, certain parameters may be used to make polishing pads including such a homogeneous polishing body compatible with conventional processing equipment or even with conventional chemical mechanical processing operations. For example, in accordance with an embodiment of the present invention, the homogeneous polishing body has a thickness in the range of 0.075 inches to 0.130 inches, e.g., in the range of 1.9 - 3.3 millimeters. In one embodiment, the homogeneous polishing body has a diameter in the range of 20 inches to 30.3 inches, e.g., in the range of 50 - 77 centimeters, and possibly in the range of 10 inches to 42 inches, e.g., in the range of 25 - 107 centimeters.

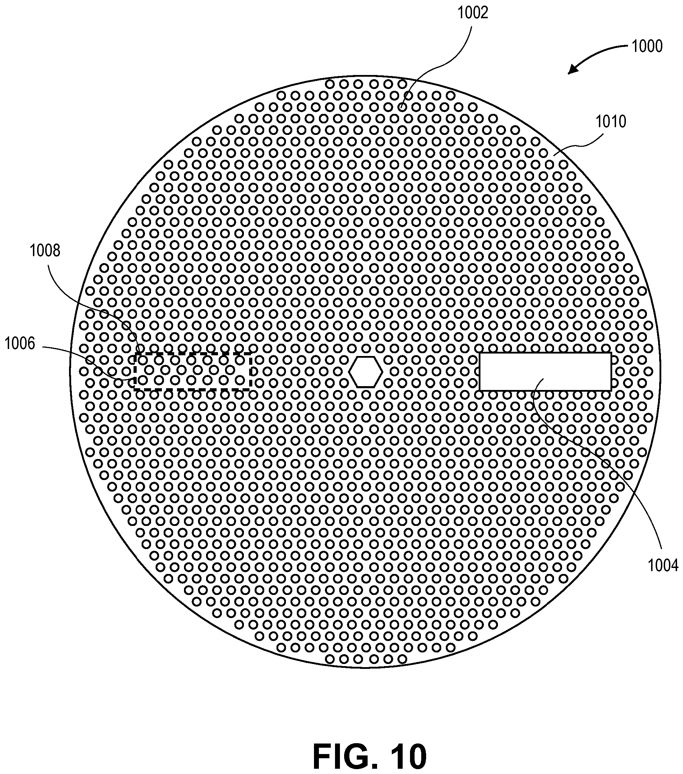

In another embodiment of the present invention, a polishing pad with a polishing surface having a plurality of continuous protrusions thereon further includes a local area transparency (LAT) region disposed in the polishing pad. For example, Figure 10 illustrates a top-down plan view of a protrusions pattern, the pattern interrupted by a local area transparency (LAT) region and/or an indication region, disposed in the polishing surface 1002 of a polishing pad 1000, not in accordance with the present invention. Specifically, a LAT region 1004 is disposed in the polishing body of polishing pad 1000. As depicted in Figure 10, the LAT region 1004 interrupts a pattern of protrusions 1010. In an embodiment, the LAT region 1004 is disposed in, and covalently bonded with, a homogeneous polishing body of the polishing pad 1000. Examples of suitable LAT regions are described in U.S. patent application 12/657,135 filed on January 13, 2010, assigned to NexPlanar Corporation, and U.S. patent application 12/895,465 filed on September 30, 2010, assigned to NexPlanar Corporation.

In an alternative embodiment, a polishing pad described herein further includes an aperture disposed in the polishing surface and polishing body. An adhesive sheet is disposed on the back surface of the polishing body. The adhesive sheet provides an impermeable seal for the aperture at the back surface of the polishing body. Examples of suitable apertures are described in U.S. patent application 13/184,395 filed on July 15, 2011, assigned to NexPlanar Corporation.

In another embodiment, a polishing pad with a polishing surface having a pattern of continuous protrusions thereon further includes a detection region for use with, e.g., an eddy current detection system. For example, referring again to Figure 10, the polishing surface 1002 of polishing pad 1000 includes an indication region 1006 indicating the location of a detection region disposed in the back surface of the polishing pad 1000. The indication region 1006 interrupts pattern of protrusions 1010 with a second pattern of protrusions 1008, as depicted in Figure 10. Examples of suitable eddy current detection regions are described in U.S. patent application 12/895,465 filed on September 30, 2010, assigned to NexPlanar Corporation.

Polishing pads described herein, such as polishing pad 200 or 800, or the above described variations thereof, may further include a foundation layer disposed on the back surface of the polishing body. The result is a polishing pad with bulk or foundation material different from the material of the polishing surface. In one embodiment, a composite polishing pad includes a foundation or bulk layer fabricated from a stable, essentially non-compressible, inert material onto which a polishing surface layer is disposed. A harder foundation layer may provide support and strength for pad integrity while a softer polishing surface layer may reduce scratching, enabling decoupling of the material properties of the polishing layer and the remainder of the polishing pad. Examples of suitable foundation layers are described in U.S. patent application 13/306,845 filed on November 29, 2011, assigned to NexPlanar Corporation.

Polishing pads described herein, such as polishing pad 200 or 800, or the above described variations thereof, may further include a sub pad disposed on the back surface of the polishing body, e.g., a conventional sub pad as known in the CMP art. The sub pad is composed of a material such as, but not limited to, foam, rubber, fiber, felt or a highly porous material.

In another aspect of the present invention, polishing a polishing surface with continuous protrusions may be fabricated in a molding process. For example, Figures 11A-11F illustrate cross-sectional views of operations used in the fabrication of a polishing pad, not in accordance with the present invention.

Referring to Figure 11A, a formation mold 1100 is provided. Referring to Figure 11B, a pre-polymer 1102 and a curative 1104 are mixed to form a mixture 1106 in the formation mold 1100, as depicted in Figure 11C. Mixing the pre-polymer 1102 and the curative 1104 includes mixing an isocyanate and an aromatic diamine compound, respectively. The mixing further includes adding an opacifying lubricant to the pre-polymer 1102 and the curative 1104 to ultimately provide an opaque molded homogeneous polishing body. The opacifying lubricant is a material such as, but not limited to: boron nitride, cerium fluoride, graphite, graphite fluoride, molybdenum sulfide, niobium sulfide, talc, tantalum sulfide, tungsten disulfide, or Teflon.

The polishing pad precursor mixture 1106 is used to ultimately form a molded homogeneous polishing body composed of a thermoset, closed cell polyurethane material. The polishing pad precursor mixture 1106 is used to ultimately form a hard pad and only a single type of curative is used. The polishing pad precursor mixture 1106 is used to ultimately form a soft pad and a combination of a primary and a secondary curative is used. For example, the pre-polymer includes a polyurethane precursor, the primary curative includes an aromatic diamine compound, and the secondary curative includes a compound having an ether linkage. The polyurethane precursor is an isocyanate, the primary curative is an aromatic diamine, and the secondary curative is a curative such as, but not limited to, polytetramethylene glycol, amino-functionalized glycol, or amino-functionalized polyoxypropylene. The pre-polymer, a primary curative, and a secondary curative have an approximate molar ratio of 100 parts pre-polymer, 85 parts primary curative, and 15 parts secondary curative. It is to be understood that variations of the ratio may be used to provide polishing pads with varying hardness values, or based on the specific nature of the pre-polymer and the first and second curatives.

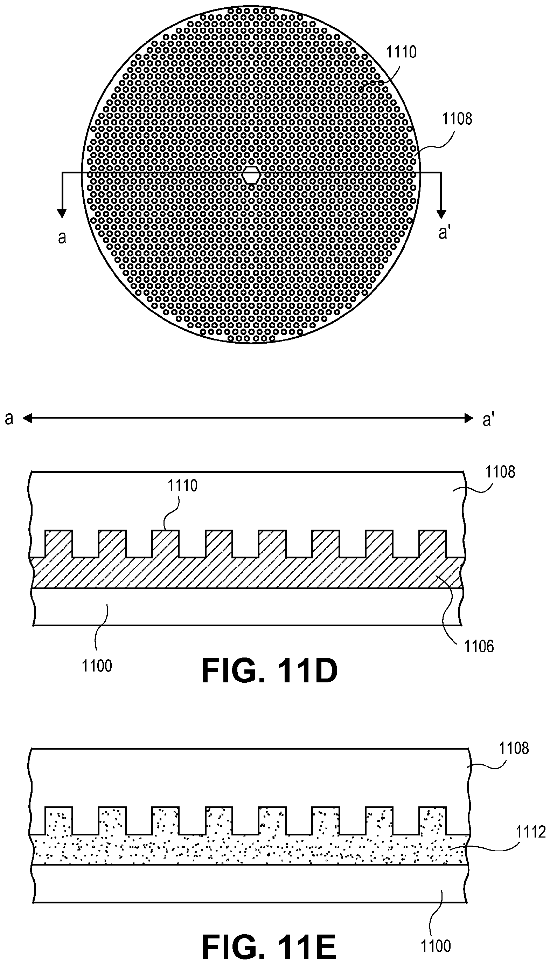

Referring to Figure 11D, a lid 1108 of the formation mold 1100 is lowered into the mixture 1106. A top-down plan view of lid 1108 is shown on top, while a cross-section along the a-a' axis is shown below in Figure 11D. The lid 1108 has disposed thereon a pattern of grooves 1110, e.g., cylindrical grooves. The pattern of grooves 1110 is used to stamp a pattern of protrusions into a polishing surface of a polishing pad formed in formation mold 1100.

It is to be understood that embodiments described herein that describe lowering the lid 1108 of a formation mold 1100 need only achieve a bringing together of the lid 1108 and a base of the formation mold 1100. That is, a base of a formation mold 1100 is raised toward a lid 1108 of a formation mold, while in other variants a lid 1108 of a formation mold 1100 is lowered toward a base of the formation mold 1100 at the same time as the base is raised toward the lid 1108.

Referring to Figure 11E, the mixture 1106 is cured to provide a molded homogeneous polishing body 1112 in the formation mold 1100. The mixture 1106 is heated under pressure (e.g., with the lid 1108 in place) to provide the molded homogeneous polishing body 1112. Heating in the formation mold 1100 includes at least partially curing in the presence of lid 1108, which encloses mixture 1106 in formation mold 1100, at a temperature approximately in the range of 93,33 - 126,67 degrees Celsius (200 - 260 degrees Fahrenheit) and a pressure in the range of 0,35 - 2,10 N/mm (2 - 12 pounds per square inch).

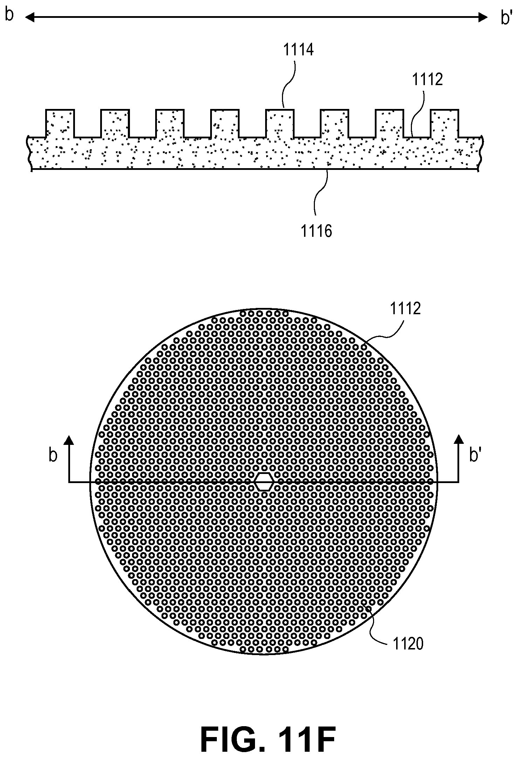

Referring to Figure 11F, a polishing pad (or polishing pad precursor, if further curing is required) is separated from lid 1108 and removed from formation mold 1100 to provide the discrete molded homogeneous polishing body 1112. A top-down plan view of molded homogeneous polishing body 1112 is shown below, while a cross-section along the b-b' axis is shown above in Figure 11F. It is noted that further curing through heating may be desirable and may be performed by placing the polishing pad in an oven and heating. Thus, in one embodiment, curing the mixture 1106 includes first partially curing in the formation mold 1100 and then further curing in an oven. Either way, a polishing pad is ultimately provided, wherein a molded homogeneous polishing body 1112 of the polishing pad has a polishing surface 1114 and a back surface 1116. The molded homogeneous polishing body 1112 is composed of a thermoset polyurethane material and a plurality of closed cell pores disposed in the thermoset polyurethane material. The molded homogeneous polishing body 1112 includes a polishing surface 1114 having disposed therein a pattern of protrusions 1120 corresponding to the pattern of grooves 1110 of the lid 1108. The pattern of protrusions 1120 may be a pattern of protrusions as described above, e.g., with respect to Figures 2A-2C, 3A, 3B, 4, 5A-5C, 6A-6D, 7, 8A-8C, 9A and 9B.

Referring again to Figure 11B, the mixing further includes adding a plurality of porogens 1122 to the pre-polymer 1102 and the curative 1104 to provide closed cell pores in the ultimately formed polishing pad. Thus, each closed cell pore has a physical shell. Referring again to Figure 11B, the mixing further includes injecting a gas 1124 into to the pre-polymer 1102 and the curative 1104, or into a product formed there from, to provide closed cell pores in the ultimately formed polishing pad. Thus, each closed cell pore has no physical shell. The mixing further includes adding a plurality of porogens 1122 to the pre-polymer 1102 and the curative 1104 to provide a first portion of closed cell pores each having a physical shell, and further injecting a gas 1124 into the pre-polymer 1102 and the curative 1104, or into a product formed there from, to provide a second portion of closed cell pores each having no physical shell. The pre-polymer 1102 is an isocyanate and the mixing further includes adding water (H₂O) to the pre-polymer 1102 and the curative 1104 to provide closed cell pores each having no physical shell.

Thus, protrusion patterns contemplated in embodiment of the present invention may be formed in-situ. For example, as described above, a compression-molding process may be used to form polishing pads with a polishing surface having a pattern of continuous protrusions. By using a molding process, highly uniform protrusion dimensions within-pad may be achieved. Furthermore, extremely reproducible protrusion dimensions along with very smooth, clean protrusion surfaces may be produced. Other advantages may include reduced defects and micro-scratches and a greater usable protrusion depth.

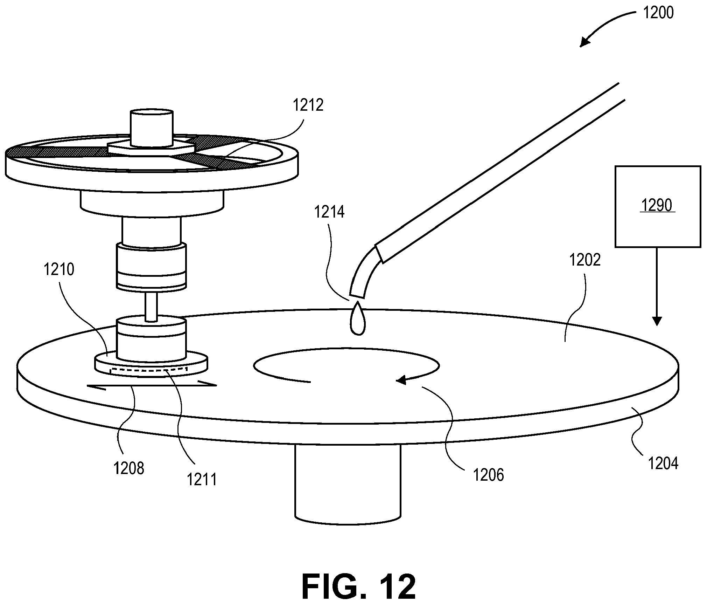

Polishing pads described herein may be suitable for use with a variety of chemical mechanical polishing apparatuses. As an example, Figure 12 illustrates an isometric side-on view of a polishing apparatus compatible with a polishing pad having a polishing surface with continuous protrusions, in accordance with an embodiment of the present invention.

Referring to Figure 12, a polishing apparatus 1200 includes a platen 1204. The top surface 1202 of platen 1204 may be used to support a polishing pad with a pattern of polishing protrusions thereon. Platen 1204 may be configured to provide spindle rotation 1206 and slider oscillation 1208. A sample carrier 1210 is used to hold, e.g., a semiconductor wafer 1211 in place during polishing of the semiconductor wafer with a polishing pad. Sample carrier 1210 is further supported by a suspension mechanism 1212. A slurry feed 1214 is included for providing slurry to a surface of a polishing pad prior to and during polishing of the semiconductor wafer. A conditioning unit 1290 may also be included and, in one embodiment, includes a diamond tip for conditioning a polishing pad.

Thus, polishing pads having a polishing surface with continuous protrusions have been disclosed. In accordance with an embodiment of the present invention, a polishing pad for polishing a substrate includes a polishing body having a polishing side opposite a back surface. The polishing pad also includes a polishing surface having a plurality of cylindrical protrusions continuous with the polishing side of the polishing body. In one embodiment, each of the plurality of cylindrical protrusions has a shape in a plane of the polishing surface such as, but not limited to, a circle, an oval, a triangle, or a polygon having five or more sides. In accordance with an embodiment of the present invention, a polishing pad for polishing a substrate includes a polishing body having a polishing side opposite a back surface.

## Claims

1. A polishing pad for polishing a substrate, the polishing pad comprising:
a polishing body having a polishing side opposite a back surface; and
a polishing surface comprising a plurality of cylindrical protrusions (702) continuous with the polishing side of the polishing body;
wherein the plurality of cylindrical protrusions is arranged in a plurality of high density regions (704) having less spacing between adjacent protrusions within a high density region than between adjacent protrusions of adjacent high density regions; wherein the cylindrical protrusions of each high density region are arranged in a hexagonal-packed pattern, the polishing pad being **characterized in that** each of the high density regions (704) has a rhombic shape, and a sub-pattern (708) of a plurality of the high density regions (704) is repeated every 60 degree rotation of the polishing pad.

2. The polishing pad of claim 1, wherein the each of the plurality of cylindrical protrusions has a shape in a plane of the polishing surface that is selected from the group consisting of a circle, an oval, a triangle, and a polygon having five or more sides.

3. The polishing pad of claim 1, further comprising:
a solid ring encompassing the plurality of cylindrical protrusions at an outer most edge of the polishing side of the polishing body, the solid ring continuous with the polishing side of the polishing body, wherein the hexagonal-packed pattern of the plurality of cylindrical protrusions terminates proximate to the ring in a staggered arrangement.

4. The polishing pad of claim 1, further comprising:
a button region disposed centrally within the hexagonal-packed pattern of the plurality of cylindrical protrusions, the button region having a hexagonal shape, wherein the button region is a raised portion of the pad material.

5. The polishing pad of claim 4, wherein the button region further comprises a triangular clocking mark on one side of the hexagonal shape, wherein the clocking mark provides pad fabrication information and/or alignment information for polishing or for adhering a pad to a platen.

6. The polishing pad of claim 1, wherein each of the plurality of cylindrical protrusions has a maximum lateral dimension approximately in the range of 1 - 30 millimeters, with a spacing between one another approximately in the range of 0.1 - 3 millimeters.

7. The polishing pad of claim 1, wherein each cylindrical protrusion of a first portion of the plurality of cylindrical protrusions has a first maximum lateral dimension, and each cylindrical protrusion of a second portion of the plurality of cylindrical protrusions has a second, different, maximum lateral dimension.

8. The polishing pad of claim 7, wherein a pattern of the plurality of cylindrical protrusions comprises a cylindrical protrusion having a maximum lateral dimension of approximately 10 millimeters surrounded by a plurality of cylindrical protrusions each having a maximum lateral dimension of approximately 1 millimeter.

9. The polishing pad of claim 1, wherein each cylindrical protrusion of a first portion of the plurality of cylindrical protrusions has a first shape in a plane of the polishing surface, and each cylindrical protrusion of a second portion of the plurality of cylindrical protrusions has a second, different, shape in the plane of the polishing surface.

10. The polishing pad of claim 1, wherein the total surface area of the plurality of cylindrical protrusions is a portion approximately in the range of 40-80% of the total surface area of the polishing side of the polishing body.

11. The polishing pad of claim 1, wherein the height of each of the plurality of cylindrical protrusions is approximately in the range of 0.5 - 1 millimeter.

12. The polishing pad of claim 1, wherein the plurality of cylindrical protrusions comprises approximately between 50,000 - 200,000 protrusions for a polishing pad having a diameter approximately in the range of 736,6 - 812,8 millimeter.

13. The polishing pad of claim 1, wherein each cylindrical protrusion of a first portion of the plurality of cylindrical protrusions has a first height from the polishing body, and each cylindrical protrusion of a second portion of the plurality of cylindrical protrusions has a second, different, height from the polishing body, but all of the plurality of cylindrical protrusions are substantially co-planar distal from the polishing body.

14. The polishing pad of claim 1, wherein the polishing body and polishing surface are together homogeneous and unitary and comprise a molded polyurethane material, which molded polyurethane material optionally has a pore density of closed cell pores in the range of 6% - 50% total void volume.

15. The polishing pad of claim 1, further comprising:
a foundation layer disposed on the back surface of the polishing body; or
a detection region disposed in the back surface of the polishing body; or
an aperture disposed in the polishing surface and polishing body and an adhesive sheet disposed on the back surface of the polishing body, the adhesive sheet providing an impermeable seal for the aperture at the back surface of the polishing body; or
a sub pad disposed on the back surface of the polishing body; or
a local area transparency (LAT) region disposed in the polishing body, the LAT region interrupting a pattern of the plurality of cylindrical protrusions.

## Patentansprüche

1. Polierpad zum Polieren eines Substrats, wobei das Polierpad Folgendes umfasst:
einen Polierkörper mit einer Polierseite gegenüber einer Rückenfläche und
eine Polierfläche, die eine Vielzahl von zylindrischen Vorsprüngen (702) umfasst, die mit der Polierseite des Polierkörpers durchgehend sind;
wobei die Vielzahl von zylindrischen Vorsprüngen in einer Vielzahl von hochdichten Regionen (704) angeordnet ist, die einen geringeren Abstand zwischen benachbarten Vorsprüngen in einer hochdichten Region als zwischen benachbarten Vorsprüngen von benachbarten hochdichten Regionen aufweisen;
wobei die zylindrischen Vorsprünge jeder hochdichten Region in einem hexagonal gepackten Muster angeordnet sind, wobei das Polierpad **dadurch gekennzeichnet ist, dass** jede der hochdichten Regionen (704) eine Rautenform aufweist und ein Untermuster (708) einer Vielzahl der hochdichten Regionen (704) alle 60 Grad einer Drehung des Polierpads wiederholt wird.

2. Polierpad nach Anspruch 1, wobei jeder der Vielzahl von zylindrischen Vorsprüngen eine Form in einer Ebene der Polierfläche aufweist, die ausgewählt ist aus der Gruppe, die aus einem Kreis, einem Oval, einem Dreieck und einem Polygon mit fünf oder mehr Seiten besteht.

3. Polierpad nach Anspruch 1, das ferner Folgendes umfasst:
einen massiven Ring, der die Vielzahl von zylindrischen Vorsprüngen an einem äußeren Rand der Polierseite des Polierkörpers umgibt, wobei der massive Ring mit der Polierseite des Polierkörpers durchgehend ist, wobei das hexagonal gepackte Muster der Vielzahl der zylindrischen Vorsprünge nahe dem Ring in einer gestuften Anordnung endet.

4. Polierpad nach Anspruch 1, das ferner Folgendes umfasst:
eine Knopfregion, die im hexagonal gepackten Muster der Vielzahl von zylindrischen Vorsprüngen mittig angeordnet ist, wobei die Knopfregion eine hexagonale Form aufweist, wobei die Knopfregion ein erhabener Abschnitt des Padmaterials ist.

5. Polierpad nach Anspruch 4, wobei die Knopfregion ferner eine dreieckige Gleichlaufinarkierung auf einer Seite der hexagonalen Form umfasst, wobei die Gleichlaufinarkierung Padherstellungsinformationen und/oder Ausrichtungsinformationen zum Polieren oder zum Kleben eines Pads auf eine Platte bereitstellt.

6. Polierpad nach Anspruch 1, wobei jeder der Vielzahl von zylindrischen Vorsprüngen eine maximale seitliche Abmessung ungefähr im Bereich von 1-30 Millimeter aufweist, bei einem Abstand voneinander ungefähr im Bereich von 0,1-3 Millimeter.

7. Polierpad nach Anspruch 1, wobei jeder zylindrische Vorsprung eines ersten Abschnitts der Vielzahl von zylindrischen Vorsprüngen eine maximale seitliche Abmessung aufweist und jeder zylindrische Vorsprung eines zweiten Abschnitts der Vielzahl von zylindrischen Vorsprüngen eine zweite, andere maximale seitliche Abmessung aufweist.

8. Polierpad nach Anspruch 7, wobei ein Muster der Vielzahl von zylindrischen Vorsprüngen einen zylindrischen Vorsprung mit einer maximalen seitlichen Abmessung von ungefähr 10 Millimeter umfasst, der von einer Vielzahl von zylindrischen Vorsprüngen umgeben ist, von denen jeder eine maximale seitliche Abmessung von ungefähr 1 Millimeter aufweist.

9. Polierpad nach Anspruch 1, wobei jeder zylindrische Vorsprung eines ersten Abschnitts der Vielzahl von zylindrischen Vorsprüngen eine erste Form in einer Ebene der Polierfläche aufweist und jeder zylindrische Vorsprung eines zweiten Abschnitts der Vielzahl von zylindrischen Vorsprüngen eine zweite, andere Form in der Ebene der Polierfläche aufweist.

10. Polierpad nach Anspruch 1, wobei die gesamte Oberfläche der Vielzahl von zylindrischen Vorsprüngen ein Abschnitt ungefähr im Bereich von 40-80 % der gesamten Oberfläche der Polierseite des Polierkörpers ist.

11. Polierpad nach Anspruch 1, wobei die Höhe jedes der Vielzahl von zylindrischen Vorsprüngen ungefähr im Bereich von 0,5-1 Millimeter liegt.

12. Polierpad nach Anspruch 1, wobei die Vielzahl von zylindrischen Vorsprüngen bei einem Polierpad mit einem Durchmesser ungefähr im Bereich von 736,6-812,8 Millimeter ungefähr zwischen 50.000-200.000 Vorsprünge umfasst.

13. Polierpad nach Anspruch 1, wobei jeder zylindrische Vorsprung eines ersten Abschnitts der Vielzahl von zylindrischen Vorsprüngen eine erste Höhe vom Polierkörper aufweist und jeder zylindrische Vorsprung eines zweiten Abschnitts der Vielzahl von zylindrischen Vorsprüngen eine zweite, andere Höhe vom Polierkörper aufweist, alle der Vielzahl von zylindrischen Vorsprüngen aber distal vom Polierkörper im Wesentlichen koplanar sind.

14. Polierpad nach Anspruch 1, wobei der Polierkörper und die Polierfläche zusammen homogen und unitär sind und ein geformtes Polyurethanmaterial umfassen, wobei das Polyurethanmaterial wahlweise eine Porendichte von geschlossenen Zellporen im Bereich von 6 % - 50 % des gesamten Hohlraumvolumens aufweist.

15. Polierpad nach Anspruch 1, das ferner Folgendes umfasst:
eine Grundschicht, die auf der Rückenfläche des Polierkörpers angeordnet ist; oder
eine Detektionsregion, die in der Rückenfläche des Polierkörpers angeordnet ist; oder
eine Öffnung, die in der Polierfläche und im Polierkörper angeordnet ist, und eine Klebefolie, die auf der Rückenfläche des Polierkörpers angeordnet ist, wobei die Klebefolie eine undurchdringliche Dichtung für die Öffnung auf der Rückenfläche des Polierkörpers bereitstellt; oder
ein Unterpad, das auf der Rückenfläche des Polierkörpers angeordnet ist; oder
eine Lokalbereichstransparanz(LAT)-Region, die im Polierkörper angeordnet ist, wobei die LAT-Region ein Muster der Vielzahl von zylindrischen Vorsprüngen unterbricht.

## Revendications

1. Tampon de polissage pour polir un substrat, le tampon de polissage comprenant :
un corps de polissage ayant une face de polissage opposée à une surface arrière ; et
une surface de polissage comprenant une pluralité de protubérances cylindriques (702) continues avec la face de polissage du corps de polissage ;
dans lequel la pluralité de protubérances cylindriques est agencée dans une pluralité de régions haute densité (704) ayant moins d'espacement entre des protubérances adjacentes à l'intérieur d'une région haute densité qu'entre des protubérances adjacentes de régions haute densité adjacentes ;
dans lequel
les protubérances cylindriques de chaque région haute densité sont agencées en un motif groupé en hexagone, le tampon de polissage étant **caractérisé en ce que** chacune des régions haute densité (704) a une forme rhombique, et un sous-motif (708) d'une pluralité des régions haute densité (704) est répété à chaque rotation de 60 degrés du tampon de polissage.

2. Tampon de polissage selon la revendication 1, dans lequel chacune de la pluralité de protubérances cylindriques a une forme dans un plan de la surface de polissage qui est sélectionnée à partir du groupe constitué de : un cercle, un ovale, un triangle, et un polygone ayant cinq faces ou plus.

3. Tampon de polissage selon la revendication 1, comprenant en outre :
un anneau solide entourant la pluralité de protubérances cylindriques à un bord le plus extérieur de la face de polissage du corps de polissage, l'anneau solide étant continu avec la face de polissage du corps de polissage, dans lequel le motif groupé en hexagone de la pluralité de protubérances cylindriques se termine à proximité de l'anneau en un agencement décalé.

4. Tampon de polissage selon la revendication 1, comprenant en outre :
une région de bouton disposée de façon centrale à l'intérieur du motif groupé en hexagone de la pluralité de protubérances cylindriques, la région de bouton ayant une forme hexagonale, dans lequel la région de bouton est une partie surélevée du matériau de tampon.

5. Tampon de polissage selon la revendication 4, dans lequel la région de bouton comprend en outre une marque d'indexage triangulaire sur une face de la forme hexagonale, dans lequel la marque d'indexage fournit des informations de fabrication de tampon et/ou des informations d'alignement pour le polissage ou pour faire adhérer un tampon à une platine.

6. Tampon de polissage selon la revendication 1, dans lequel chacune de la pluralité de protubérances cylindriques a une dimension latérale maximum approximativement dans la plage d'1 à 30 millimètres, avec un espacement les une entre les autres approximativement dans la plage de 0,1 à 3 millimètres.

7. Tampon de polissage selon la revendication 1, dans lequel chaque protubérance cylindrique d'une première partie de la pluralité de protubérances cylindriques a une première dimension latérale maximum, et chaque protubérance cylindrique d'une seconde partie de la pluralité de protubérances cylindriques a une seconde dimension latérale maximum différente.

8. Tampon de polissage selon la revendication 7, dans lequel un motif de la pluralité de protubérances cylindriques comprend une protubérance cylindrique ayant une dimension latérale maximum d'approximativement 10 millimètres entourée par une pluralité de protubérances cylindriques ayant chacune une dimension latérale maximum d'approximativement 1 millimètre.

9. Tampon de polissage selon la revendication 1, dans lequel chaque protubérance cylindrique d'une première partie de la pluralité de protubérances cylindriques a une première forme dans un plan de la surface de polissage, et chaque protubérance cylindrique d'une seconde partie de la pluralité de protubérances cylindriques a une seconde forme différente dans le plane de la surface de polissage.

10. Tampon de polissage selon la revendication 1, dans lequel la superficie totale de la pluralité de protubérances cylindriques est une portion approximativement dans la plage de 40 à 80 % de la superficie totale de la face de polissage du corps de polissage.

11. Tampon de polissage selon la revendication 1, dans lequel la hauteur de chacune de la pluralité de protubérances cylindriques est approximativement dans la plage de 0,5 à 1 millimètre.

12. Tampon de polissage selon la revendication 1, dans lequel la pluralité de protubérances cylindriques comprend approximativement entre 50000 à 200000 protubérances pour un tampon de polissage ayant un diamètre approximativement dans la plage de 736,6 à 812,8 millimètre.

13. Tampon de polissage selon la revendication 1, dans lequel chaque protubérance cylindrique d'une première partie de la pluralité de protubérances cylindriques a une première hauteur depuis le corps de polissage, et chaque protubérance cylindrique d'une seconde partie de la pluralité de protubérances cylindriques a une seconde hauteur différente depuis le corps de polissage, mais la totalité de la pluralité de protubérances cylindriques sont sensiblement distales, de façon coplanaire, par rapport au corps de polissage.

14. Tampon de polissage selon la revendication 1, dans lequel le corps de polissage et la surface de polissage sont conjointement homogènes et unitaires et comprennent un matériau polyuréthane moulé, lequel matériau polyuréthane moulé a optionnellement une densité des pores alvéolaires fermés dans la plage de 6 % à 50 % du volume de vide total.

15. Tampon de polissage selon la revendication 1, comprenant en outre :
une couche de fondation disposée sur la surface arrière du corps de polissage ; ou
une région de détection disposée dans la surface arrière du corps de polissage ; ou
une ouverture disposée dans la surface de polissage et le corps de polissage et une feuille adhésive disposée sur la surface arrière du corps de polissage, la feuille adhésive fournissant un scellage imperméable pour l'ouverture sur la surface arrière du corps de polissage ; ou
un sous-tampon disposé sur la surface arrière du corps de polissage ; ou
une région de transparence locale (LAT) disposée dans le corps de polissage, la région de LAT interrompant un motif de la pluralité de protubérances cylindriques.
